# EUROPÄISCHE PATENTANMELDUNG

(11) **EP 4 084 061 A1**
(43) Veröffentlichungstag der Anmeldung: **02.11.2022**
(21) Anmeldenummer: 21170995.1
(22) Anmeldetag: 28.04.2021
(51) Int. Cl.: H01L 23/48, H01L 21/60, H01L 23/31, H01L 23/498

(54) **SCHALTUNGSTRÄGER SOWIE VERFAHREN ZUM HERSTELLEN EINER ELEKTRISCHEN VERBINDUNG MIT DIESEM**

(71) Anmelder: Siemens Aktiengesellschaft, 80333 München (DE)
(72) Erfinder: Feil, Wolfgang, 92421 Schwandorf (DE); Kiefl, Stefan, 80992 München (DE); Schaller, Karl-Heinz, 92289 Ursensollen (DE); Stegmeier, Stefan, 81825 München (DE)

(57) **Zusammenfassung**

Die vorliegende Erfindung betrifft einen Schaltungsträger (10) mit einem ersten Kontakt (11) auf einem im wesentlichen flächigen Bereich des Schaltungsträgers und einem zweiten Kontakt (23, 24), der in einer Ebene liegt, die von dem flächigen Bereich verschieden ist. Dabei bilden der erste Kontakt und der zweite Kontakt eine Aufnahme (25) für ein auf mindestes zwei Seiten kontaktierbares Schaltungselement (30). Der der erste Kontakt (11) des Schaltungsträgers ist ausgebildet, mit einem auf einer Schaltungsträgerseite des Schaltungselements angeordneten ersten Kontakt (31) des Schaltungselements elektrisch leitend kontaktiert zu werden und der zweite Kontakt (23, 24) des Schaltungsträgers ist ausgebildet, mit einem auf einer der Schaltungsträgerseite abgewandten Seite des Schaltungselements angeordneten zweiten Kontakt (32, 33) des Schaltungselements (30) elektrisch leitend kontaktiert zu werden.

Die vorliegende Erfindung betrifft ferner ein Verfahren zum Herstellen einer elektrischen Verbindung zwischen einem derartigen Schaltungsträger (10) und einem Schaltungselement (30) .

## Beschreibung

Die vorliegende Erfindung betrifft eine neuartige Aufbau- und Verbindungstechnik, insbesondere für die Leistungselektronik.

Die Aufbau- und Verbindungstechnik hat die Aufgabe, elektrische und mechanische Verbindungen zwischen den einzelnen Elementen einer Schaltung und ggf. einem Schaltungsträger zu schaffen.

Insbesondere für Leistungshalbleiter hat es sich als vorteilhaft herausgestellt, diese mit Kontakten oder Kontaktflächen an mehreren Seiten auszustatten, also beispielsweise mit leiterplattenseitigen Kontakten und oberseitigen Kontakten. Verschiedene Aufbau- und Verbindungstechniken sind bekannt und in der Publikation "Applikationshandbuch Leistungshalbleiter", Herausgeber Semikron International GmbH, 2. Auflage 2015, ISBN 978-3-938843-85-7, in Kapitel 2.5 ausführlich beschrieben.

Das dort beschriebene Drahtbonden an der Oberseite hat allerdings den Nachteil, dass während der Herstellung der Verbindung Kräfte aufgewendet werden, durch welche das Halbleiterbauelement beschädigt werden können. Zudem können im Betrieb lokale Temperaturerhöhungen entstehen, denen durch die Verwendung von mehreren Bonddrähten und dem sogenannten Stitching nur bedingt entgegengewirkt werden kann. Die Kontaktierungspunkte sind unvermeidbar einer punktuellen thermischen Belastung ausgesetzt und auch die Bonddrähte erwärmen sich aufgrund des während des Betriebs durch sie fließenden Stroms und ihres durch das Bondverfahren begrenzten Querschnitts. Ferner können aufgrund von Induktion in den Bonddrähten unerwünschte elektrische Störsignale in die Schaltung eingebracht werden, insbesondere kann bei parallel verlaufenden Bonddrähten, die zu verschiedenen Kontakten führen, ein unerwünschtes Übersprechen auftreten.

Als Alternative zu Bonddrähten sind u.a. aus vorstehend genannter Publikation Sinterverfahren bekannt, die im Gegensatz zu den Bonddrähten flächige Verbindungen mit deutlich größeren Querschnitten erlauben und sowohl trägerseitig als auch oberseitig einsetzbar sind und sich gegenüber Lötverbindungen durch eine deutlich höhere Temperaturbeständigkeit auszeichnen. Nachteilig an diesen Sinterverfahren ist jedoch der hohe Fertigungsaufwand bei Bestückung der Leiterplatten bzw. Schaltungsträger und insbesondere der hohe Druck, der für den Sintervorgang erforderlich ist.

Schließlich sind u.a. ebenfalls aus der vorstehend genannten Publikation Druckkontaktierungen bekannt, die an die Stelle der vorgenannten stoffschlüssigen Verbindungsarten treten. Dabei gleiten die verbundenen Partner aufeinander und vermeiden damit thermische Spannungen, die bei den stoffschlüssigen Verbindungen im Betrieb zwangsläufig auftreten und z.B. mittels geeignet flexibler Materialien kompensiert werden müssen. Druckkontaktierungen haben allerdings den Nachteil, dass auf den Halbleiter dauerhaft Druck ausgeübt wird, der sich mit der Temperatur ändert und das Halbleiterbauelement im Laufe der Zeit beschädigen kann. Zudem erfordern flächige Kontaktierungen perfekt ebene Flächen und es muss sichergestellt werden, dass die aufeinander gleitenden Kontakte dauerhaft frei von Verschmutzungen und Oxidschichten bleiben.

Eine Aufgabe der vorliegenden Erfindung ist es, eine weiter verbesserte Aufbau- und Verbindungstechnik anzugeben.

Diese Aufgabe wird durch einen Schaltungsträger besonders geformten Kontakten gelöst. Ein erster Kontakt des Schaltungsträgers ist dabei auf einem im wesentlichen flächigen Bereich des Schaltungsträgers angeordnet. Ein zweiter Kontakt des Schaltungsträgers ist in einer Ebene angeordnet, die von dem flächigen Bereich bzw. der Ebene, in welcher der flächige Bereich liegt, verschieden ist. Der erste Kontakt und der zweite Kontakt bilden eine Aufnahme für ein auf mindestes zwei Seiten kontaktierbares Schaltungselement. Dabei ist erste Kontakt des Schaltungsträgers ausgebildet, mit einem auf einer Schaltungsträgerseite des Schaltungselements angeordneten ersten Kontakt des Schaltungselements elektrisch leitend kontaktiert zu werden. Der zweite Kontakt des Schaltungsträgers ist ausgebildet, mit einem auf einer der Schaltungsträgerseite abgewandten Seite des Schaltungselements angeordneten zweiten Kontakt des Schaltungselements elektrisch leitend kontaktiert zu werden.

Anders ausgedrückt wird eine Aufnahme für Bauelemente, insbesondere für Leistungshalbleiter, geschaffen, die (mit Bezug auf die bevorzugte Einbaurichtung gesehen) sowohl trägerseitig als auch oberseitig Kontakte aufweisen. Diese Aufnahme wird durch die genannten zweiten Kontakte zumindest teilweise definiert. Nach Einsetzen des Bauelements in die Aufnahme werten die leiterplattenseitigen ersten Kontakte dauerhaft kontaktiert und die oberseitigen zweiten Kontakte ebenfalls.

Die so gebildete Aufnahme kann auch als Kavität betrachtet werden, die eine Unter- und eine Oberseite aufweist, wobei sowohl an der Unterseite als auch an der Oberseite Kontaktmittel angebracht sind. In diese Kavität wird das Bauelement, vorzugsweise ein Halbleiterbauelement, eingesetzt und anschließend werden Kontaktmittel des Bauelements mit den Kontaktmitteln des Schaltungsträgers, die in der Kavität angeordnet sind oder diese bilden, durch Pressung, Löten, Sintern, Kleben oder einem anderen bekannten Verfahren dauerhaft elektrisch leitend kontaktiert.

Sowohl trägerseitig als auch oberseitig können mehrere Kontakte bzw. Kontaktpaare bestehend aus jeweils einem Schaltungsträgerkontakt und einem Bauelementekontakt vorgesehen werden.

In einer vorteilhaften Weiterbildung der vorliegenden Erfindung kann der Schaltungsträger außer Kontakten bzw. Kontaktmitteln noch mindestens ein Führungs- und/oder Begrenzungselement aufweisen, welches die Aufnahme begrenzt und/oder das Schaltungselement beim Einführen in die Aufnahme führt.

Ein besonders geeignetes Fertigungsverfahren sowohl für die sich aus der Trägerebene in z-Richtung heraus erhebenden, die Aufnahme oberseitig begrenzenden Kontakte aus auch für die Führungs- und/oder Begrenzungselemente ist ein schichtbasiertes additives Fertigungsverfahrens, auch als 3D-Druck bekannt. Insbesondere eignen sich pulverbettbasierte laseradditive Fertigungsverfahren wie der Rakelprozess, bei dem Schicht für Schicht durch eine Lasereinkopplung in ein Metallpulver und anschließendes Entfernen von nicht aufgeschmolzenem Metallpulver eine elektrisch leitfähige, eine Aufnahme bzw. Kavität bildende Struktur in z-Richtung hergestellt werden kann. Nichtleitende Führungs- und/oder Begrenzungselemente können durch kunststoffbasierte additive Verfahren hergestellt werden.

Die vorliegende Erfindung betrifft ferner ein Verfahren zum Herstellen einer elektrischen Verbindung zwischen den Kontakten eines Schaltungsträgers der vorstehend beschriebenen Art und den Kontakten eines Schaltungselements, das mindestens einen trägerseitigen und mindestens einen oberseitigen Kontakt aufweist. Gemäß des Verfahrens wird das Schaltungselement in die Aufnahme eingeführt und anschließend werden die Kontaktpaare dauerhaft kontaktiert, in vorteilhaften Weiterbildungen der vorliegenden Erfindung mechanisch mittels Form- und/oder Kraftschluss und/oder stoffschlüssig, insbesondere mittels Pressverbindung, Lötverbindung, Sinterverbindung, Ultraschallschweißen, Laserschweißen und/oder Klebeverbindung. Dabei können die trägerseitigen Kontaktpaare mit dem gleichen oder mit einem anderen Kontaktierungsverfahren kontaktiert werden als die oberseitigen Kontaktpaare.

In vorteilhaften Weiterbildungen wird dabei in einem zusätzlichen Schritt ein Fügematerial, insbesondere ein Lot, auf die Kontakte des Schaltungselements aufgebracht, bevor das Schaltungselement in die Aufnahme eingeführt wird.

In vorteilhaften Weiterbildungen der Erfindung wird anschließend ein isolierendes Material in die Aufnahme bzw. Kavität eingebracht wird, um die dort nach dem Einführen des Schaltungselements und nach dem Kontaktieren verbliebenen Hohlräume auszufüllen und eine dauerhafte Isolierung hoher Qualität beispielsweise zwischen den einzelnen Kontaktpaaren zu gewährleisten.

Dabei kann zusätzliches isolierendes Material auf den Schaltungsträger aufgebracht werden, so dass auch die zweiten Kontakte vollständig von isolierendem Material umgeben sind, d.h. so dass die Kavität und das darin eingesetzte Schaltungselement nicht nur ausgefüllt, sondern von isolierendem Material umschlossen sind.

Die Vorteile der vorliegenden Erfindung sind darin zu sehen, dass die Positionierung des Schaltungselements auf dem Schaltungsträger durch die Aufnahme unterstützt wird, insbesondere durch die zusätzlichen Führungs- und/oder Begrenzungselemente. Insbesondere die oberseitige Kontaktierung des Schaltungselements wird vereinfacht und gegenüber beispielsweise einem Bonding-Verfahren verbessert, da die flächige Kontaktierung demgegenüber niederinduktiv ist. Das Verfahren kann zudem flexibel angepasst werden und ist auch für kleine Losgrößen wirtschaftlich und selbst für Losgrößen von 1 gut anwendbar.

Im folgenden werden Ausführungsbeispiele der vorliegenden Erfindung anhand von Zeichnungen näher erläutert. Es sei darauf hingewiesen, dass sämtliche vorstehend und nachfolgend offenbarten Varianten, Ausgestaltungen und Ausführungsbeispiele uneingeschränkt miteinander kombinierbar sind.

Es zeigen:
Fig. 1 in schematischer Darstellung eine Draufsicht auf einen Schaltungsträger gemäß eines Ausführungsbeispiels der vorliegenden Erfindung mit bereits eingesetztem Schaltungselement;
Fig. 2A den Schaltungsträger aus Fig. 1 in schematischer Schnittdarstellung, wobei das Schaltungselement noch nicht in die Aufnahme eingesetzt ist;
Fig. 2B den Schaltungsträger aus Fig. 1 in schematischer Schnittdarstellung, wobei das Schaltungselement in die Aufnahme eingesetzt und kontaktiert ist;
Fig. 2C den Schaltungsträger aus Fig. 1 nach Ein-/Aufbringen des isolierenden Materials.

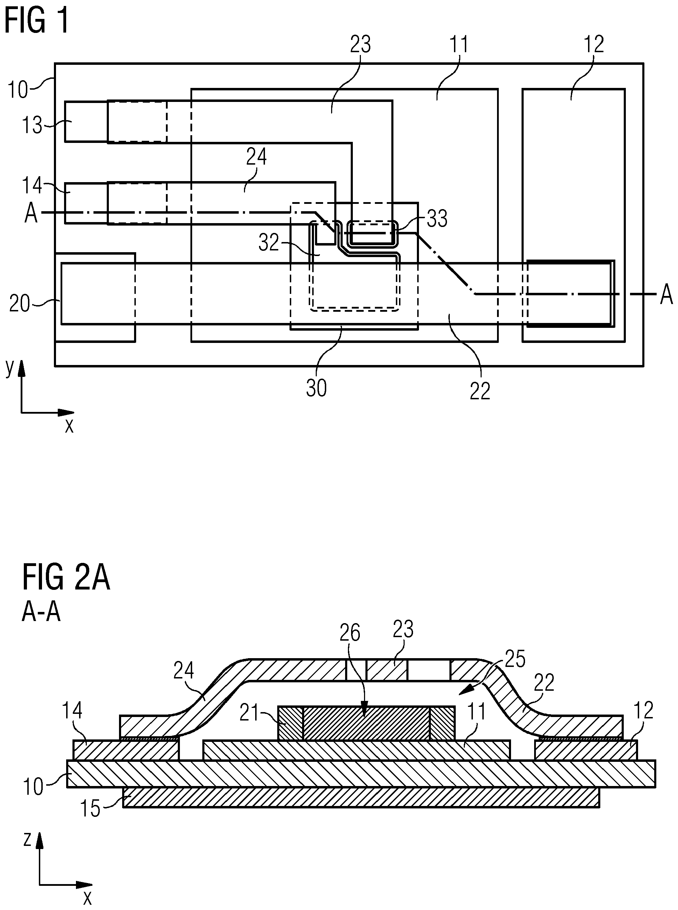

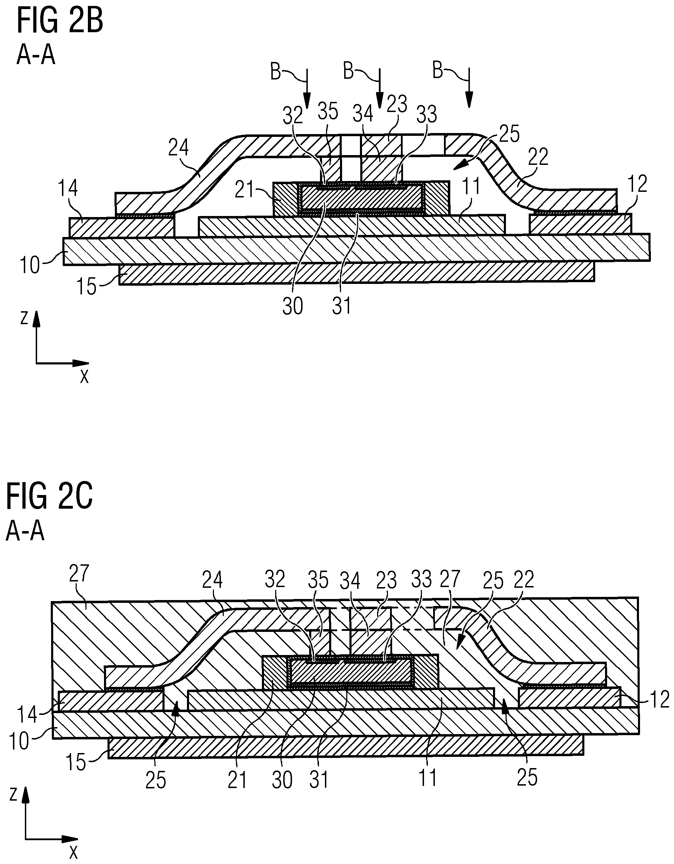

Fig. 1 zeigt in schematischer Darstellung eine Draufsicht auf einen Schaltungsträger 10. Fig. 2A-C zeigen den Schaltungsträger 10 in einer Schnittdarstellung entlang der Schnittlinie A-A in verschiedenen Zuständen. Fig. 1 und Fig. 2 werden im folgenden gemeinsam erläutert.

Der beispielhaft dargestellte Schaltungsträger 10 weist mehrere bestückungsseitige Leiterflächen 11, 12, 13, 14 auf sowie eine unterseitige Leiterfläche 15. Eine erste bestückungsseitige Leiterfläche 11 bildet einen ersten, unterseitigen Kontakt des Schaltungsträgers 10 zur Kontaktierung mit einem ersten Kontakt 31 eines Leistungshalbleiters 30.

Von einer zweiten oberseitigen Leiterfläche 12 ausgehend und elektrisch leitend mit der zweiten Leiterfläche 12 verbunden ist ein erstes Kontaktband 22 gebildet, das sich in z-Richtung von der durch den Schaltungsträger beschriebenen Ebene abhebt und zumindest teilweise parallel zu der durch den Schaltungsträger beschriebenen Ebene (ohne Beschränkung der Allgemeinheit sei dies hier die x-y-Ebene) verläuft. Das erste Kontaktband 22 kann mit einem zweiten Kontakt 32 des Leistungshalbleiters oberseitig kontaktiert werden und kann zusätzlich einen Kontakt 20 des in Fig. 1 gezeigten Schaltungsmoduls zur Kontaktierung des Moduls mit einer anderen/übergeordneten Baugruppe aufweisen, der hier aber nicht weiter betrachtet wird.

Von einer dritten oberseitigen Leiterfläche 13 des Schaltungsträgers 10 ausgehend und elektrisch leitend mit der dritten Leiterfläche 13 verbunden ist ein zweites Kontaktband 23 gebildet, das sich ebenfalls in z-Richtung von der durch den Schaltungsträger beschriebenen Ebene abhebt und ebenfalls zumindest teilweise parallel zu der durch den Schaltungsträger 10 beschriebenen Ebene verläuft. Das zweite Kontaktband 23 dient der oberseitigen Kontaktierung mit einem dritten Kontakt 33 des Leistungshalbleiters. Das zweite Kontaktband 23 verläuft teilweise schwebend mit definiertem Abstand in z-Richtung über der ersten Leiterfläche 11, ohne diese zu berühren und kann vorteilhaft in einem späteren Fertigungsschritt durch Isoliermaterial in dieser definierten Beabstandung zur ersten Leiterfläche 11 fixiert werden.

Von einer vierten oberseitigen Leiterfläche 14 des Schaltungsträgers 10 ausgehend und elektrisch leitend mit der vierten Leiterfläche 14 verbunden ist ein drittes Kontaktband 24 gebildet, das sich ebenfalls in z-Richtung von der durch den Schaltungsträger 10 beschriebenen Ebene abhebt und ebenfalls zumindest teilweise parallel zu der durch den Schaltungsträger 10 beschriebenen Ebene verläuft. Das dritte Kontaktband 24 dient der oberseitigen Kontaktierung mit dem zweiten Kontakt 32 des Leistungshalbleiters 30. Das dritte Kontaktband 24 verläuft ebenfalls teilweise schwebend mit definiertem Abstand in z-Richtung über der ersten Leiterfläche 11, ohne diese zu berühren. Auch das dritte Kontaktband 24 kann vorteilhaft in einem späteren Fertigungsschritt durch Isoliermaterial in dieser definierten Beabstandung zur ersten Leiterfläche 11 fixiert werden.

Die drei Kontaktbänder 22, 23, 24 dienen nicht nur der späteren Kontaktierung mit den oberseitigen Kontakten 32, 33 des Leistungshalbleiters 30, sondern sind auch Teil der räumlichen Begrenzung der Aufnahme bzw. Kavität 25, wie insbesondere aus Fig. 2 ersichtlich wird. Insbesondere bilden die drei Kontaktbänder eine Begrenzung der Kavität 25 in z-Richtung, können aber zusätzlich auch eine Begrenzung und/oder eine Führung in x/y-Richtung bilden.

Zusätzlich können gesonderte Begrenzungs- und/oder Führungsmittel 21 vorgesehen sein, durch die eine besonders präzise Führung des Halbleiters 30 für den Einsetzvorgang des Halbleiters 30 in die Aufnahme 25 bewirkt werden kann. Solche Führungsmittel können aus nichtleitendem Material auf dem Schaltungsträger 10 und beispielsweise auf der ersten Leiterfläche 11 aufgebracht werden, insbesondere durch ein additives Fertigungsverfahren bzw. durch 3D-Druck. In Fig. 2A ist beispielhaft ein Führungsmittel 21 gezeigt, das eine dreiseitige Führung bzw. Begrenzung für den Leistungshalbleiter 30 bietet und eine Öffnung 26 beschreibt, die passend zu den äußeren Abmessungen des Leistungshalbleiters 30 dimensioniert ist, und zwar so, dass dieser mit möglichst wenig Spiel in diese Öffnung einsetzbar ist. Dies wird verdeutlicht durch Fig. 2B, in welcher der Leistungshalbleiter 30 im in die Öffnung 26 eingesetzten Zustand gezeigt ist.

Der Leistungshalbleiter 30 wird also in die in Fig. 2A dargestellte Aufnahme bzw. Kavität 25 eingesetzt und dabei optional durch die Begrenzungs- und/oder Führungsmittel 21 präzise(r) geführt. Durch die Begrenzungs- und/oder Führungsmittel 21 können auch Steuerkontakte des Leistungshalbleiters 30 wie beispielsweise ein Gate-Anschluss exakt angebunden werden. Das Einsetzen des Leistungshalbleiters 30 erfolgt dabei vorzugsweise seitlich (in Fig. 1 von der dort unten dargestellten Kante des Schaltungsträgers her) in die Kavität 25 mittels eines Roboters mit geeigneter Greifhilfe. Dabei können zusätzlich zu oder anstelle der mechanischen Begrenzungs- und/oder Führungsmittel 21 optische Marker (nicht dargestellt) auf dem Schaltungsträger 10 und beispielsweise auf der ersten Leiterfläche 11 aufgebracht werden, um eine optische Führung des Greifers des Roboters zu ermöglichen.

Das Einführen des Leistungshalbleiters in die Aufnahme bzw. Kavität 25 kann in anderen Ausführungsbeispielen von oben erfolgen (nicht dargestellt). In diesem Fall sind die Kontaktbänder so gestaltet, dass der Fügebereich zunächst frei bleibt und das Einsetzen des Leistungshalbleiters von oben her erfolgen kann. Anschließend werden die Kontaktierungspunkte der Kontaktbänder durch Biegen der Kontaktbänder mit den oberseitigen Kontakten des Halbleiters ausgerichtet. Dabei kann ein seitliches Biegen (parallel zur x-y-Ebene) und/oder ein Biegen von oben (in eine Ebene parallel zur x-y-Ebene hinein) erfolgen. Beispielsweise können die halbleiterseitigen Enden der Kontaktbänder zunächst im wesentlichen senkrecht nach oben stehen, so dass der Fügebereich freigehalten wird. Nach dem Einsetzen des Halbleiters werden diese Enden dann um ca. 90 Grad in Richtung des Halbleiters gebogen, um anschließend in den weiteren Fertigungsschritten mit den entsprechenden Kontakten des Halbleiters kontaktiert werden zu können.

Natürlich ist es in weiteren Ausführungsbeispielen möglich, das Einsetzen von der Seite und von oben zu kombinieren, beispielsweisen indem einige Kontaktbänder bereits parallel zur x-y-Ebene ausgerichtet sind und der Halbleiter seitlich von oben unter diese Kontaktbänder positioniert wird und weitere Kontaktbänder anschließend durch Biegen ausgerichtet werden.

Die oberseitigen Kontakte 32, 33 des Leistungshalbleiters 30 können in Ausführungsbeispielen vor dem Einsetzen in die Aufnahme 25 mit Fügemitteln bzw. Fügematerial 34, 35 versehen werden, beispielsweise mit einem Lot, einem Sinter, einer Lot-Preform oder einem Klebstoff oder einer Klebstoffkomponente. Natürlich können auch trägerseitige Kontakte 31 des Leistungshalbleiters vor dem Einsetzen in die Aufnahme mit Fügemitteln bzw. Fügematerial versehen werden (nicht dargestellt) .

Zusätzlich oder alternativ können auch die zur Kontaktierung mit dem Leistungshalbleiter vorgesehenen Abschnitte der Kontaktbänder und/oder der Leiterfläche 11 mit Fügemitteln bzw. Fügematerial versehen werden, beispielsweise ebenfalls mit einem Lot, einem Sinter, einer Lot-Preform oder einem Klebstoff oder einer Klebstoffkomponente (nicht dargestellt). Auch sind zusätzliche Fügemittel in Form eines Podests denkbar, beispielsweise ein auf der ersten Leiterfläche 11 im Kontaktbereich mit dem ersten Kontakt 31 des Leistungshalbleiters 30 aufgebrachtes Podest (nicht dargestellt).

Nach dem Einsetzen des Leistungshalbleiters 30 in die Aufnahme 25 können in Ausgestaltungen der Erfindung die Kontaktbänder 22, 23, 24 in z-Richtung verformt werden, beispielsweise durch Krafteinwirkung angedeutet durch Pfeile B in Fig. 2B, oder durch thermische Prozesse. Dabei werden die Kontaktbänder in Kontakt mit den entsprechenden oberseitigen Kontakten des Leistungshalbleiters gebracht, ggf. unterstützt durch die Fügemittel bzw. das Fügematerial 34, 35, und die Kontaktierung der trägerseitigen sowie der oberseitigen Kontaktpaare wird dabei mechanisch hergestellt. Gleichzeitig wird der Leistungshalbleiter in der Montageposition fixiert. Zusätzlich oder alternativ zu einer Krafteinwirkung können thermische oder ultraschallbasierte Fügeverfahren verwendet werden, um dauerhafte elektrische Verbindungen der träger- und oberseitigen Kontaktpaare herzustellen. Dabei kann die oberseitige und die trägerseitige Kontaktierung in einem Schritt oder in aufeinanderfolgenden Schritten erfolgen. Geeignete Verfahren sind dabei Löten, insbesondere Diffusionslöten, Sintern, Kleben, Anpressen und/oder Schweißen, insbesondere Ultraschallschweißen.

In Ausführungsbeispielen beträgt die Schichtdicke, d.h. die Materialstärke in z-Richtung, der Kontaktbänder 22, 23, 24 zwischen 10 Mikrometer und 2000 Mikrometer. Dadurch wird das Verformen, insbesondere das Biegen der Kontaktbänder und deren Andrücken an den Leistungshalbleiter erleichtert.

In Ausführungsbeispielen werden Leistungshalbleiter 30 eingesetzt, bei denen einige oder alle Kontakte als (zusätzliches) Fügemittel 33, 34 sogenannte Bond-Buffer aufweisen, wodurch höhere Druckkräfte absorbiert und/oder größere Schmelzzonen erreicht werden können.

Nach Herstellung der Kontaktierungen zwischen den Kontaktpaaren kann zur Verbesserung der Isolationseigenschaften der Schaltung und/oder zur Erfüllung entsprechender Anforderungen an die Isolation eine Verfüllung der Kavität 25 mit einem Isoliermaterial 27 vorgenommen werden. Das Ergebnis dieser Verfüllung ist in Fig. 2C gezeigt. Das Isolationsmaterial, beispielsweise ein flüssiges silikon-basiertes Material, wurde durch eine oder mehrere der Öffnungen der Kavität eingebracht und bildet nach Aushärten den Isolator 27, der insbesondere auch seitliche Isolationsstrecken wie z.B. zwischen dem Emitterpad und den Chipaußenkanten sicherstellt.

Im Beispiel Fig. 2C wurde zusätzlich der gesamte Schaltungsträger 10 mit einer Schicht aus dem Isoliermaterial 27 versehen. Damit werden auch die nicht zur Kavität 25 gehörenden Räume zwischen den Kontaktbändern 22, 23, 24 und dem Schaltungsträger 10 verfüllt, was den Kontaktbändern zusätzliche Stabilität verleiht und die Abstände und die Isolation zwischen den Kontaktbändern und den damit jeweils nicht verbundenen Leiterflächen dauerhaft sicherstellt. Vorzugsweise füllt das Isoliermaterial 27 auch Bereiche zwischen den Leiterflächen 11, 12, 13, 14 aus und verbessert somit auch deren Isolationseigenschaften.

Es sei darauf hingewiesen, dass in den Darstellungen und im vorstehenden Text die Begriffe bzw. die räumliche Orientierung "oben", "unten", "horizontal", "vertikal" bezogen auf die fachübliche Darstellung mit dem Schaltungsträger (beispielsweise eine Leiterplatte) unten und den Bauelementen darauf angeordnet gewählt wurde, d.h. der Träger ist "unten" und definiert insoweit eine "Unterseite" bzw. "Trägerseite" des Bauelements und entsprechend eine "Oberseite". Dies ist nicht einschränkend zu verstehen, da natürlich der Einbau des fertig bestückten Trägers in einer beliebigen Orientierung in ein Gerät erfolgen kann und auch das Gerät selbst in mehreren Orientierungen betrieben werden kann. Die Begriffe "dem Träger zugewandte Seite/Fläche des Bauelements" entsprechend unten bzw. trägerseitig und "die zu der dem Träger zugewandten Seite/Fläche parallele Seite/Fläche des Bauelements" entsprechend oben beschreiben dies besser und wurden hier lediglich der besseren Lesbarkeit zuliebe nicht oder jedenfalls nicht durchgängig verwendet.

Es sei ferner darauf hingewiesen, dass hier nur ausgewählte Ausführungsbeispiele beschrieben wurden, die sich die vorliegende Erfindung zunutze machen. Insbesondere ist es beispielsweise möglich, die Aufnahme bzw. Kavität zumindest teilweise in einer Vertiefung des Schaltungsträgers anzuordnen (nicht dargestellt); dabei kann dann beispielsweise das Material des Schaltungsträgers zumindest teilweise die Funktion des oder der Begrenzungs- und/oder Führungsmittel übernehmen.

Der Begriff "Kavität" und der allgemeinere Begriff "Aufnahme" bezeichnen einen teilweise durch auf dem Schaltungsträger angeordneten, umschlossenen Bereich, in welchen der Leistungshalbleiter eingebracht werden kann. Die Herstellung der Aufnahme kann dabei zumindest teilweise mittels additiver Fertigungsverfahren erfolgen, aber auch zumindest teilweise mit anderen Verfahren. Beispielsweise ist es möglich, Leadframes als Kontaktbänder zu verwenden und diese auf die entsprechenden Leiterflächen aufzulöten. Die Kavität bzw. Aufnahme ist jeweils so gestaltet, dass nachfolgend von einer der Raumrichtungen der Leistungshalbleiter eingebracht werden kann, z.B. durch Einschieben.

Schließlich sei darauf hingewiesen, dass die Ausführungsbeispiele der vorliegenden Erfindung auf Leistungshalbleiter Bezug nehmen, weil dort die zuverlässige, möglichst großflächige, möglichst chipnahe und deswegen möglichst ohne Zuführung von viel Wärme durchgeführte Kontaktierung von besonderer Bedeutung ist. Die Erfindung ist aber natürlich nicht auf Leistungshalbleiter beschränkt, sondern im Zusammenhang mit allen auf Schaltungsträgern montierbaren Bauelementen, aktiv oder passiv, einsetzbar.

## Patentansprüche

1. Schaltungsträger (10) mit einem ersten Kontakt (11) auf einem im wesentlichen flächigen Bereich des Schaltungsträgers und einem zweiten Kontakt (23, 24), der in einer Ebene liegt, die von dem flächigen Bereich verschieden ist, wobei der erste Kontakt und der zweite Kontakt eine Aufnahme (25) für ein auf mindestes zwei Seiten kontaktierbares Schaltungselement (30) bilden und wobei der erste Kontakt (11) des Schaltungsträgers ausgebildet ist, mit einem auf einer Schaltungsträgerseite des Schaltungselements angeordneten ersten Kontakt (31) des Schaltungselements elektrisch leitend kontaktiert zu werden und wobei der zweite Kontakt (23, 24) des Schaltungsträgers ausgebildet ist, mit einem auf einer der Schaltungsträgerseite abgewandten Seite des Schaltungselements angeordneten zweiten Kontakt (32, 33) des Schaltungselements (30) elektrisch leitend kontaktiert zu werden.

2. Schaltungsträger nach Anspruch 1 mit mehreren ersten und mehreren zweiten Kontakten.

3. Schaltungsträger nach einem der Ansprüche 1 oder 2, welcher zusätzlich mindestens ein Führungs- und/oder Begrenzungselement (21) aufweist, welches die Aufnahme (25) begrenzt und/oder das Schaltungselement beim Einführen in die Aufnahme führt.

4. Schaltungsträger nach einem der Ansprüche 1 bis 3, dessen zweiter Kontakt oder dessen zweite Kontakte und/oder dessen Führungs- und/oder Begrenzungselement mittels eines additiven Fertigungsverfahrens, vorzugsweise mittels eines schichtbasierten additiven Fertigungsverfahrens, hergestellt sind.

5. Verfahren zum Herstellen einer elektrischen Verbindung mit folgenden Schritten:
- Bereitstellen eines Schaltungsträgers (10) gemäß eines der Ansprüche 1 bis 3;
- Einführen eines Schaltungselements (30) in die Aufnahme (25) ;
- Kontaktieren eines auf einer Schaltungsträgerseite des Schaltungselements angeordneten ersten Kontakts (31) des Schaltungselements mit dem ersten Kontakt (11) des Schaltungsträgers, und
- Kontaktieren eines auf einer der Schaltungsträgerseite abgewandten Seite des Schaltungselements angeordneten zweiten Kontakts (32, 33) des Schaltungselements mit dem zweiten Kontakt (23, 24) des Schaltungsträgers.

6. Verfahren nach Anspruch 5, bei dem der Schritt des Bereitstellens des Schaltungsträgers das Herstellen des zweiten Kontakts oder der zweiten Kontakte und/oder des mindestens einen Führungs- und/oder Begrenzungselements (21) des Schaltungsträgers mittels eines schichtbasierten additiven Fertigungsverfahrens umfasst.

7. Verfahren nach einem der Ansprüche 5 oder 6, bei dem die Kontaktierung der ersten Kontakte mechanisch mittels Form- und/oder Kraftschluss und/oder stoffschlüssig erfolgt, insbesondere mittels Pressverbindung, Lötverbindung, Sinterverbindung, Ultraschallschweißen, Laserschweißen und/oder Klebeverbindung.

8. Verfahren nach einem der Ansprüche 5 bis 7, bei dem die Kontaktierung der zweiten Kontakte mechanisch mittels Form- und/oder Kraftschluss und/oder stoffschlüssig erfolgt, insbesondere mittels Pressverbindung, Lötverbindung, Sinterverbindung, Ultraschallschweißen, Laserschweißen und/oder Klebeverbindung.

9. Verfahren nach einem der Ansprüche 5 bis 8, bei dem in einem zusätzlichen Schritt ein Fügematerial (34, 35), insbesondere ein Lot, auf die Kontakte des Schaltungselements und/oder die Kontakte des Schaltungsträgers (11, 23, 24) aufgebracht wird, bevor das Schaltungselement in die Aufnahme eingeführt wird.

10. Verfahren nach einem der Ansprüche 5 bis 9, bei dem nach dem Kontaktieren ein isolierendes Material (27) in die Aufnahme (25) eingebracht wird, um dort nach dem Kontaktieren verbliebene Hohlräume auszufüllen.

11. Verfahren nach Anspruch 10, bei dem zusätzliches isolierendes Material auf den Schaltungsträger aufgebracht wird, so dass auch die zweiten Kontakte vollständig von isolierendem Material umgeben sind.

12. Verfahren nach einem der Ansprüche 5 bis 11, bei dem das Einführen des Schaltungselements (30) in die Aufnahme (25) im Wesentlichen parallel zum Schaltungsträger (10) erfolgt.

13. Verfahren nach einem der Ansprüche 5 bis 11, bei dem das Einführen des Schaltungselements (30) nicht parallel zum Schaltungsträger (30) erfolgt, insbesondere im Wesentlichen senkrecht zum Schaltungsträger (30), wobei sich der zweite Kontakt oder die zweiten Kontakte (23, 24) zunächst außerhalb des Fügebereichs befinden und nach Einführen des Schaltungselements (30) in die Aufnahme (25) durch Biegen mit dem jeweiligen oberseitigen Kontakt (32, 33) des Schaltungselements (30) ausgerichtet werden.
